# EUROPÄISCHE PATENTSCHRIFT

(11) **EP 3 172 774 B1**
(45) Veröffentlichungstag und Bekanntmachung des Hinweises auf die Patenterteilung: **23.01.2019**
(21) Anmeldenummer: 15760082.6
(22) Anmeldetag: 22.07.2015
(51) Int. Cl.: H01L 41/053

(54) **AKTORVORRICHTUNG**
ACTUATOR DEVICE
APPAREIL D'ACTUATEUR

(30) Priorität: 23.07.2014 DE 102014214318; 14.11.2014 DE 102014116708
(43) Veröffentlichungstag der Anmeldung: 31.05.2017
(73) Patentinhaber: Physik Instrumente (PI) GmbH & Co. KG, 76228 Karlsruhe (DE)
(72) Erfinder: MARTH, Harry, 76337 Waldbronn (DE); PERTSCH, Patrick, 07629 Hermsdorf (DE); ZHAO, Oskar Xiabin, 201316 Shanghai (CN)
(74) Vertreter: Kruspig, Volkmar
(86) Internationale Anmeldenummer: PCT/DE2015/200411
(87) Internationale Veröffentlichungsnummer: WO 2016/012021

(56) Entgegenhaltungen:
- DE-A1- 10 148 267
- US-A- 3 952 216
- US-B2- 8 653 719

## Beschreibung

Die Erfindung betrifft eine Aktorvorrichtung nach Anspruch 1 und eine Anordnung mit einer Vielzahl solcher Aktorvorrichtungen nach Anspruch 9.

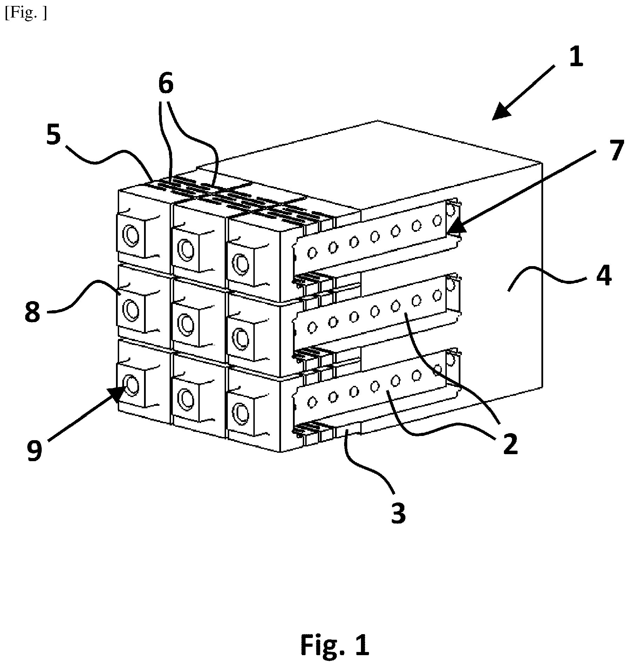

Aus dem wissenschaftlichen Artikel ,Structure and closed-loop control of a novel compact deformable mirror for wavefront correction in a high power laser system', Laser Phys. Lett. 10 (2013) (045301) (7pp) ist eine Aktorvorrichtung mit insgesamt 64 PZT-Aktoren in einer 8x8-Matrix bekannt, wobei die Aktorvorrichtung dazu vorgesehen ist, den Spiegel eines Lasersystems gezielt zu deformieren, um die Wellenfrontaberration des Laserstrahls zu korrigieren. Figur 1 des vorgenannten Artikels zeigt im Detail die konstruktive Gestaltung der Aktoranordnung bzw. -halterung, bei welcher der Aktor mittels einer Feder und einer Spannschraube mit einer Druck-Vorspannung beaufschlagt wird. Diese Druck-Vorspannung ist notwendig, um zu verhindern, dass der entsprechende Aktor eine Zugbeanspruchung erfährt, da die PZT-Keramik des Aktors schon bei sehr geringen Zugbelastungen Schaden nehmen kann.

Nachteilig an dieser Konstruktion ist der komplizierte Aufbau mit zahlreichen Einzelteilen, der die Montage extrem aufwändig macht, und die umso komplexer wird, je mehr Aktoren die Aktorvorrichtung umfasst. Die Montage wird weiterhin erschwert durch die Notwendigkeit der Durchführung der Anschlussleitungen durch die Verschraubung am unteren Ende des jeweiligen Aktors. Weiterhin nehmen die verwendeten Einzelteile einen relativ großen Raum ein, so dass eine Miniaturisierung der entsprechenden Aktorvorrichtung schnell an ihre Grenzen stößt. Insbesondere aufgrund der entsprechenden Anordnung der Druckfeder ist die räumliche Ausdehnung über die Grundfläche des Aktors hinaus relativ groß, so dass der Abstand benachbarter Aktoren (Pitch) ebenfalls relativ groß ist.

Aus der DE 10 2006 032 995 A1 ist ein elektromechanischer Motor mit einer Aktorvorrichtung bekannt, bei welcher die piezoelektrischen Aktoren über Federbänder mit hohen Drückkräften vorgespannt sind, wobei die Federbänder an Strukturelementen des Motors befestigt sind. Nachteilig hierbei ist die Befestigung der unter hoher Zugspannung stehenden Federbänder während der Montage, beispielsweise durch ein Schweißverfahren, insbesondere dann, wenn die Aktorvorrichtung eine Vielzahl von Aktoren und eine entsprechend hohe Anzahl an Federbändern aufweist. Ein Anbringen der Federbänder bei einer Arrayanordnung von Aktoren, die in hintereinanderliegenden Reihen angeordnet sind, ist bei den entsprechend innenliegenden und von allen Seiten mit Nachbaraktoren umgebenen Aktoren schwierig bis unmöglich.

Es ist daher Aufgabe der Erfindung, eine Aktorvorrichtung bereitzustellen, welche die Nachteile der aus dem zuvor genannten Stand der Technik bekannten Aktorvorrichtungen überwindet. Insbesondere ist es Aufgabe der Erfindung, eine Aktorvorrichtung mit einer Vielzahl von Aktoren bereitzustellen, die sich einfach und schnell herstellen lässt und bei der eine Miniaturisierung mit sehr geringem Abstand zwischen benachbarten Aktoren einfach realisierbar ist.

Es wird ebenso Bezug auf den Stand der Technik in den jeweiligen Dokumenten DE10148267 und US3952216 genommen.

Die vorliegende Erfindung definiert eine Aktorvorrichtug nach dem unabhängigen Vorrichtungsanspruch 1.

Jedes Gehäuse ist integral bzw. einstückig mit einem gemeinsamen Basiselement ausgeführt. ,Gemeinsames Basiselement' bedeutet hierbei, dass alle Gehäuse mit dem gleichen und für alle Gehäuse gemeinsamen Basiselement verbunden sind. Durch einen integral mit dem Gehäuse ausgebildeten federnden Abschnitt erfolgt eine Beaufschlagung des Aktors mit einer mechanischen Druckkraft in einem bestimmten und definierten Bereich, wobei die Wirkrichtung der Druckkraft parallel zur Richtung der Längsausdehnung bzw. parallel zur Längenänderungsrichtung des Aktors verläuft.

Durch die integrale oder einstückige Ausführung aller Gehäuse mit dem gemeinsamen Basiselement zusammen mit dem in jedem Gehäuse integral vorhandenen federnden Abschnitt, welcher die zum zuverlässigen und dauerhaften Betrieb der Aktoren notwendige Druckkraft aufbringt, gelingt eine äußerst kompakte und dabei montagetechnisch einfach und schnell realisierbare Aktorvorrichtung mit einem sehr geringen Abstand bzw. Pitch zwischen benachbarten Aktoren, da das Gehäuse nur geringfügig mehr Raum einnimmt als der Aktor selbst. Zudem ist bei einem solchen Aufbau, der keinerlei Verschraubungen aufweist, die Handhabung der an dem Aktor zur elektrischen Ansteuerung vorgesehenen Anschlussleitungen bzw. deren Führung/ Durchführung vergleichsweise einfach. Die Montage bzw. der Gehäuseeinsatz der Aktoren selbst gelingt bei der erfindungsgemäßen Aktorvorrichtung ebenfalls einfach und unkompliziert.

In bevorzugter Weise ist jedes Gehäuse von wenigstens zwei benachbarten Gehäusen umgeben ist, wobei in besonders bevorzugter Weise die Richtungen, in welchen die benachbarten Gehäuse angeordnet sind, im Wesentlichen senkrecht aufeinander stehen bzw. einen Winkel von 90° einschließen. ,Im Wesentlichen' bedeutet in diesem Zusammenhang, dass der Winkel geringfügig, d.h. um +/- 5%, von 90° abweichen kann.

Es kann sich als günstig erweisen, dass der federnde Abschnitt durch Schlitze im Gehäuse gebildet ist, wobei sich die Schlitze in vorteilhafter Weise in einer Richtung erstrecken, die senkrecht zur Längserstreckungsrichtung des Gehäuses verläuft. Diese Schlitze sorgen für die notwendige Flexibilität bzw. Federwirkung des Gehäuseabschnitts, wobei durch die Schlitze im Gehäuse in den entsprechenden Abschnitten des verbleibenden Gehäusematerials Festkörpergelenke ausgebildet werden. Neben Schlitzen sind andere Formen von Ausnehmungen an dem Gehäuse denkbar, die ebenfalls zu einer Federwirkung des Gehäuseabschnitts führen.

Es kann sich auch als günstig erweisen, dass das zumindest ein Teil der Gehäuse eine Öffnung oder einen Durchbruch aufweist, in welche/welchen der Aktor in seiner Längsausrichtung, d.h. hochkant, einsetzbar, vorzugsweise einschiebbar, ist. Hierdurch gelingt eine besonders einfache Montage der Aktorvorrichtung, insbesondere dann, wenn diese mehr als zwei Reihen von Aktoren aufweist. Dann ist das Einsetzen bzw. Einschieben innenliegender Aktoren, also von Aktoren, die näher am oder im Zentrum der Matrixanordnung von Aktoren angeordnet sind, relativ einfach realisierbar.

Die Öffnung bzw. der Durchbruch ist dabei so gestaltet, dass deren bzw. dessen Ausdehnung in Längsrichtung vor dem Einsetzen bzw. Platzieren des Aktors geringfügig kleiner ist als die Längenausdehnung des darin einzusetzenden Aktors, wobei die Ausdehnung der Öffnung bzw. des Durchbruchs quer zur Längsrichtung derart bemessen ist, dass ein von Null verschiedener Abstand zwischen dem in der Öffnung bzw. dem Durchbruch eingesetzten Aktor und dem Gehäuse bzw. dem Basiselement besteht. Aufgrund dieser Ausgestaltung der Öffnung bzw. des Durchbruchs ist der Aktor nach dem Einsetzen in die Öffnung bzw. in den Durchbruch fest über seine beiden Stimflächenseiten eingespannt bzw. mit einer Druckspannung beaufschlagt, wobei die übrigen Seitenflächen des Aktors freie Flächen sind und keinen Kontakt zum Gehäuse haben bzw. beabstandet zum Gehäuse angeordnet sind.

Außerdem kann es sich als günstig erweisen, dass wenigstens ein Gehäuse ein Kontaktelement aufweist, welches zum direkten oder indirekten Kontakt mit einem durch die Aktoren zu bewegenden oder zu deformierenden Element vorgesehen ist.

Hierbei kann es sich als günstig erweisen, dass das Kontaktelement eine Halteeinrichtung, bevorzugt in Form eines Gewindes und mehr bevorzugt in Form eines Innengewindes, aufweist. Hiermit gelingt eine einfache Montage der Aktorvorrichtung, bei welcher eine Längung des Gehäuses zum Einsetzen bzw. Einschieben des Aktors notwendig ist, da die Öffnung/der Durchbruch in ihrer Längsausdehnung kleiner ist als die Längsausdehnung des Aktors. Bei Vorsehen eines Innengewindes kann ein Haltemittel eingeschraubt werden, über welches sehr einfach eine entsprechende Zugkraft auf das Gehäuse ausgeübt werden kann.

Weiterhin kann es sich hierbei als günstig erweisen, dass das Kontaktelement einen Entkopplungsabschnitt aufweist, welcher die Einleitung von Kräften quer zur Längenänderungsrichtung des Aktors reduziert oder eliminiert. Auch Querkräfte können insbesondere bei einem piezokeramischen Werkstoff des Aktors leicht zu einem Schaden an diesem führen.

Schließlich kann es sich hierbei als günstig erweisen, dass das Kontaktelement integral mit dem Gehäuse ausgebildet ist. Hierdurch gelingt ein äußerst kompakter und montagefreundlicher Aufbau der Aktorvorrichtung.

Die Erfindung betrifft zudem eine Anordnung bzw. eine Arrayanordnung umfassend eine Vielzahl der zuvor beschriebenen Aktorvorrichtungen, wobei sich benachbarte Aktorvorrichtungen zumindest abschnittsweise kontaktieren. Hierdurch kann auf einfache und montagefreundliche Weise eine Anordnung bzw. ein Array mit einer hohen Zahl von dicht nebeneinander angeordneten Aktoren erzielt werden. In besonders bevorzugter Weise kontaktieren sich die benachbarten Aktorvorrichtungen über ebene Flächen bzw. Seitenflächen des Basiselements.

Hierbei kann es vorteilhaft sein, dass die Aktorvorrichtungen jeweils über das Basiselement mit einer Grundplatte verbunden sind. In besonders vorteilhafter Weise sind die Aktorvorrichtungen in die Grundplatte eingelassen bzw. eingesetzt, so dass entweder nur das jeweilige Gehäuse bzw. ein Teil des Gehäuses oder nur das jeweilige Kontaktelement über die Grundplatte hinausragt.

Es zeigen in schematischer und nicht maßstäblicher Darstellung:
Fig. 1: Eine Ausführungsform einer erfindungsgemäßen Aktorvorrichtung
Fig. 2: Eine Ausführungsform einer Anordnung der erfindungsgemäßen Aktorvorrichtung gemäß Fig. 1
Fig. 3: Anordnung gemäß Fig. 2 in anderer Ansicht
Fig. 4: Weitere Ausführungsform einer erfindungsgemäßen Aktorvorrichtung
Fig. 5: Eine Ausführungsform einer Anordnung der erfindungsgemäßen Aktorvorrichtung gemäß Fig. 4
Fig. 6: Anordnung gemäß Fig. 5 in anderer Ansicht

Figur 1 zeigt eine mögliche Ausführungsform der erfindungsgemäßen Aktorvorrichtung 1 mit insgesamt neun Aktoren 2 und entsprechend neun die Aktoren umgebenden Gehäusen 3 in einer 3x3-Matrixanordnung. Hierbei sind die einzelnen Gehäuse 3 einstückig bzw. integral mit dem gemeinsamen Basiselement 4 ausgeführt. Das Basiselement und die einzelnen Gehäuse bestehen hierbei aus einem metallischen Material. Die Verwendung anderer Materialien, z.B. von Kunststoffen, insbesondere verstärkten Kunststoffen, ist ebenso möglich.

Die Form bzw. Struktur der Gehäuse ist durch ein Erodierverfahren realisiert. Dabei ist der eine federnde Wirkung aufweisende Abschnitt 5 des Gehäuses 3 mit länglichen und parallel zueinander angeordneten Schlitzen bzw. Ausnehmungen 6 versehen, wobei die Schlitze bzw. Ausnehmungen jeweils quer zur Längsausdehnung des Gehäuses verlaufen. Das verbleibende Material des Gehäuses im Umgebungsbereich der Schlitze bildet hierbei Festkörpergelenke aus, die für eine definierte Flexibilität bzw. Federwirkung des entsprechenden Gehäuseabschnitts sorgen. Weitere Formen von Ausnehmungen bzw. Einkerbungen, die auch zu der gewünschten Federwirkung des Gehäuseabschnitts führen, sind ebenso denkbar, beispielsweise ellipsenförmige oder knochenförmige Ausnehmungen bzw. Einkerbungen.

Jedes Gehäuse 3 weist einen Gehäusedurchbruch 7 auf, in welchen jeweils ein piezoelektrischer Aktor eingesetzt ist. Hierbei steht der jeweilige Aktor einerseits mit einer seiner flächenmäßig kleinsten Seitenflächen, welche eine Stirnfläche bildet, in Kontakt mit der entsprechenden Innenseite bzw. Innenfläche des Gehäuses bzw. stützt sich an dieser ab. Andererseits steht der gleiche Aktor mit seiner anderen und gegenüberliegend angeordneten flächenmäßig kleinsten Seitenfläche, die ebenfalls eine Stirnfläche bildet, mit der entsprechenden Fläche des Basiselements in Kontakt bzw. stützt sich an dieser ebenso ab. Keine der übrigen Seitenflächen des Aktors steht in Kontakt mit einer Fläche des Gehäuses bzw. des Basiselements, so dass die Längenänderung des Aktors hierdurch nicht behindert wird.

Dadurch, dass der Durchbruch 7 eine Längsausdehnung aufweist, die vor dem Einsetzen des Aktors um einen definierten Betrag kleiner ist als die Längsausdehnung des einzusetzenden Aktors, ist dieser nach dem Einsetzen in den Durchbruch mit einer Druckspannung beaufschlagt, wobei die Druckspannung bei den gegebenen Materialien von Basiselement und Gehäuse im Wesentlichen durch die Ausgestaltung des Gehäuses beeinflusst ist. So lässt sich durch die spezifische Lage bzw. Anordnung und Form der in dem Gehäuse eingebrachten Schlitze bzw. Ausnehmungen und die Differenz zwischen der Längsausdehnung des Durchbruchs 7 und der Längsausdehnung des Aktors vor dessen Einsetzen in den Durchbruch eine Druckvorspannung in einem definierten Bereich erzielen.

Die Grundfläche eines Aktors beträgt 3x3mm², während die Grundfläche eines Gehäuses 5x5mm² beträgt. Der Abstand zwischen benachbarten Gehäusen beträgt 0,5 mm. Die vorgenannten Abmessungen bzw. Abstände können verändert und insbesondere weiter reduziert werden, um eine Miniaturisierung der Aktorvorrichtung zu realisieren. Dieser Miniaturisierung sind lediglich durch die nach unten begrenzten Abmessungen des Aktors bzw. dessen Querschnittsfläche Grenzen gesetzt.

Bei jedem Gehäuse ist an seinem freien Ende ein Kontaktelement 8 vorgesehen, welches einstückig oder integral mit dem Gehäuse 3 ausgeführt ist. Es ist jedoch auch möglich, das Kontaktelement stoffschlüssig, etwa durch Kleben, Löten oder Schweißen, mit dem Gehäuse zu verbinden. Jedes Kontaktelement weist eine Quaderform auf, wobei andere geometrische Formen ebenso denkbar sind, beispielsweise eine Stift- oder Pilzform.

Bei dieser Art des Vorsehens von Kontaktelementen ist es beispielsweise möglich, nach Montage der einzelnen Aktoren in den jeweiligen Gehäusedurchbrüchen einen Höhenunterschied zwischen einzelnen Kontaktelementen einfach durch einen Planschleifprozess zu eliminieren.

Jedes Kontaktelement 8 ist mit einer Halteeinrichtung 9 in Form eines Innengewindes versehen, mit dessen Hilfe auf einfache Weise eine Zugkraft auf das entsprechende Gehäuse aufbringbar ist. Dies kann beispielsweise durch Einschrauben eines Elements, beispielsweise eines Hakens, mit entsprechendem Außengewinde in die Halteeinrichtung geschehen, wobei über die Aufbringung einer Zugkraft an dem Haken diese auf das Gehäuse übertragen wird. Durch das Einwirken der Zugkraft auf das Gehäuse mit seinem elastischen und federnden Abschnitt 5 ergibt sich eine Längenänderung bzw. Längenvergrößerung des Gehäuses bzw. dem entsprechenden Durchbruch 7, so dass der jeweilige Aktor, dessen Längsausdehnung größer ist als die entsprechende Längsausdehnung des jeweiligen Durchbruchs, in den Durchbruch leicht einsetzbar oder einschiebbar ist. Durch anschließende Zugkraftentlastung versucht das Gehäuse aufgrund der federnden bzw. elastischen Wirkung des federnden Abschnitts 5, seine ursprüngliche Abmessung vor Zugkraftaufbringung einzunehmen. Da jetzt aber der Aktor in den Durchbruch eingesetzt ist, ist ein Zurückkehren in die ursprüngliche Dimension ausgeschlossen. Aufgrund der nun resultierenden Längung des Gehäuses mit seinem federnden Abschnitt ergibt sich als Konsequenz die Ausübung einer Druckkraft auf den Aktor durch das ihn umgebende Gehäuse in Richtung seiner Längsausdehnung.

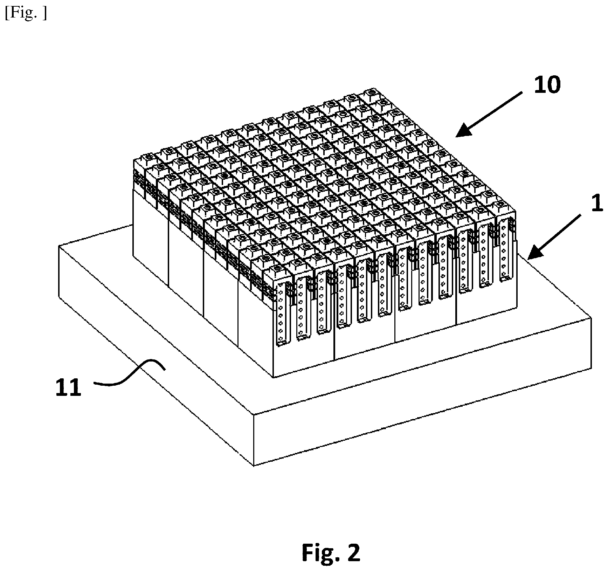

Das in Fig. 1 gezeigte 3x3-Modul kann aufgrund seiner ebenen Seitenflächen einfach mit weiteren entsprechenden Aktorvorrichtungen erweitert werden, die nur an das bestehende Modul angesetzt werden müssen. Fig 2. zeigt eine entsprechende (Array-)Anordnung 10 mit insgesamt 16 Aktorvorrichtungen 1 gemäß Fig. 1. Hierbei stoßen die einzelnen Aktorvorrichtungen aneinander bzw. berühren sich jeweils im Bereich des Basiselements. Jede Aktorvorrichtung ist mit der Grundplatte 11 verschraubt.

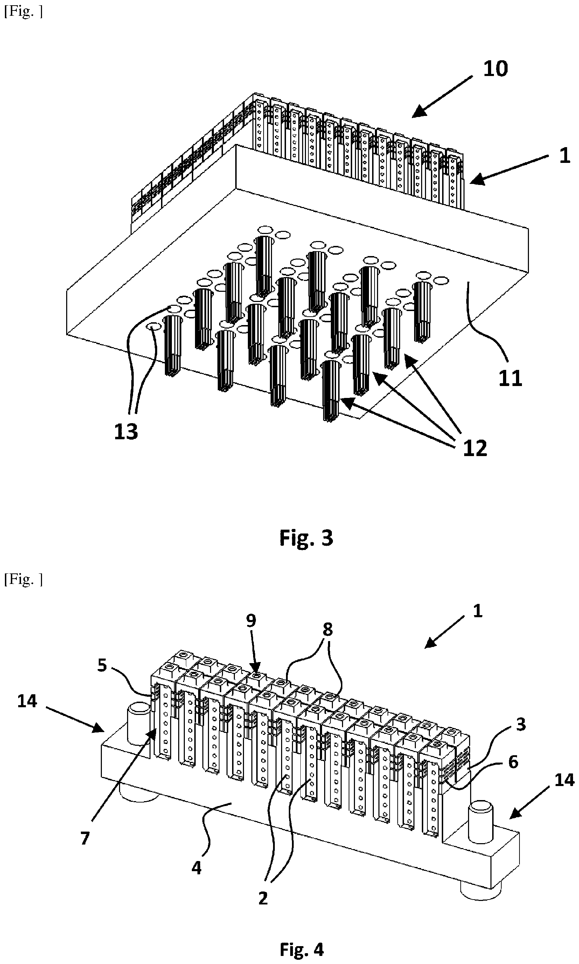

Fig. 3 zeigt die (Array-)Anordnung von Fig. 2 in einer Ansicht von unten, so dass hierbei auch die Unterseite der Grundplatte 11 zu sehen ist. Diese ist mit zahlreichen Durchgangsbohrungen 13 versehen, über welche zum Einen die Aktorvorrichtungen mittels Schrauben mit der Grundplatte verbunden sind, und durch die zum Anderen die mit den Aktoren verbundenen und zu deren Ansteuerung dienenden elektrischen Leitungen 12 geführt sind.

Fig. 4 zeigt eine weitere mögliche Ausführungsform der erfindungsgemäßen Aktorvorrichtung. Diese unterscheidet sich von der in Fig. 1 gezeigten Aktorvorrichtung in erster Linie dadurch, dass hier eine andere Anordnung der Aktoren 2 bzw. der sie umgebenden Gehäuse 3 zueinander vorliegt, und dass das gemeinsame Basiselement 4, mit welchem alle Gehäuse 3 einstückig oder integral ausgeführt sind, eine andere geometrische Form aufweist. Konkret weist die Aktorvorrichtung zwei Reihen mit jeweils 12 Aktoren auf; es handelt sich also um ein 12x2-Modul. Der Aufbau der die Aktoren umgebenden Gehäuse ist identisch zu dem Aufbau der Gehäuse der Aktorvorrichtung gemäß Fig. 1 und wurde oben bereits ausführlich beschrieben. Die Form des Basiselements 4 ist zunächst der 12x2-Anordnung der Aktoren geschuldet, und weist dementsprechend eine langgestreckte Form auf. Am jeweiligen distalen Endabschnitt weist das Basiselement einen Absatz bzw. eine Stufe auf, so dass ein Befestigungsabschnitt 14 resultiert, über den die Aktorvorrichtung an einer Grundplatte befestigbar ist. Hierzu weist der Befestigungsabschnitt eine Durchgangsbohrung zur Aufnahme einer Schraube auf.

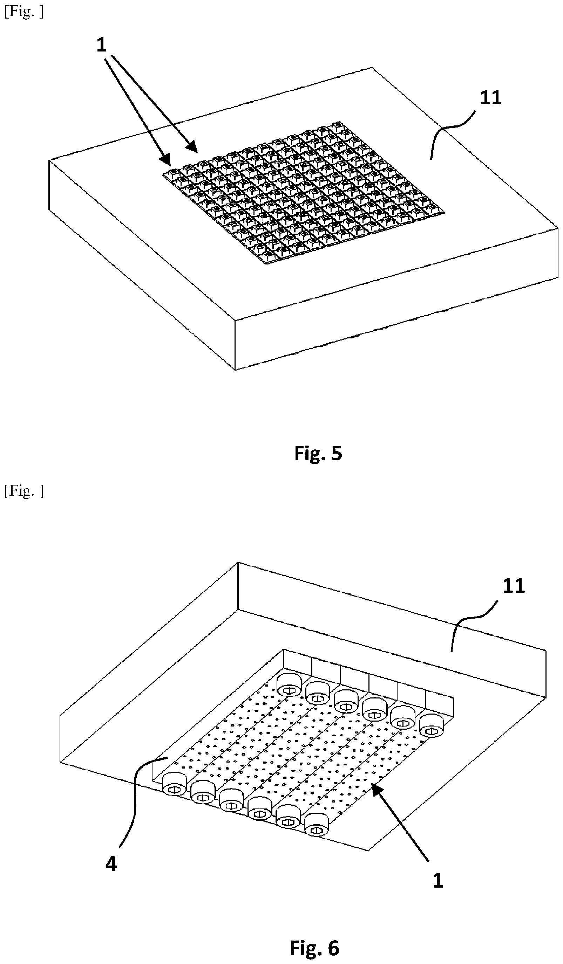

Fig. 5 zeigt eine (Array-)Anordnung, bei der insgesamt 6 der 12x2-Module gemäß Fig. 4 in die Grundplatte 11 eingelassen sind, so dass an der Oberseite der Grundplatte im Wesentlichen nur die Kontaktelemente 8 hervorschauen bzw. über die durch die Oberseite der Grundplatte gebildete Ebene hinausragen. Die Aktorvorrichtungen stehen über die langen Seitenflächen ihres Basiselements in Kontakt miteinander und sind von unten über die Befestigungsabschnitte 14 mit Hilfe von Schrauben mit der Grundplatte verbunden bzw. verschraubt. Dies ist anhand von Fig. 6 zu erkennen, welches die Arrayanordnung gemäß Fig. 5 in einer Ansicht von unten, d.h. mit Blick auf die Unterseite der Grundplatte, zeigt.

Im Gegensatz zur (Array-)Anordnung gemäß den Figuren 2 und 3 weist hier nicht die Grundplatte Durchgangsbohrungen auf, sondern die jeweilige Aktorvorrichtung bzw. deren Basiselement. Diese dienen hier jedoch nur der Durchführung der zu den Aktoren führenden elektrischen Leitungen.

## Patentansprüche

1. Aktorvorrichtung (1) mit wenigstens vier elektrisch ansteuerbaren, längenveränderlichen, Aktoren (2), die jeweils durch ein separates Gehäuse (3) in das jeweils einer von ihnen eingesetzt ist, mit einem integral ausgebildeten federnden Abschnitt (5) in ihrer Längenänderungsrichtung mit einer Druckkraft beaufschlagt sind, **dadurch gekennzeichnet, dass**
jedes Gehäuse (3) einstückig mit einem für alle Gehäuse gemeinsamen Basiselement (4) ausgeführt ist.

2. Aktorvorrichtung nach Anspruch 1, **dadurch gekennzeichnet, dass** jedes Gehäuse (3) von wenigstens zwei benachbarten Gehäusen (3) umgeben ist.

3. Aktorvorrichtung nach Anspruch 1 oder 2, **dadurch gekennzeichnet, dass** der federnde Abschnitt durch Schlitze (6) im Gehäuse (3) gebildet ist.

4. Aktorvorrichtung nach einem der vorhergehenden Ansprüche, **dadurch gekennzeichnet, dass** zumindest ein Teil der Gehäuse eine Öffnung oder einen Durchbruch (7) aufweist, in welche/welchen der Aktor in seiner Längsausrichtung einsetzbar, vorzugsweise einschiebbar, ist.

5. Aktorvorrichtung nach einem der vorhergehenden Ansprüche, **dadurch gekennzeichnet, dass** wenigstens ein Gehäuse (3) ein Kontaktelement (8) aufweist, welches zum Kontakt mit einem durch die Aktoren zu bewegenden oder zu deformierenden Element vorgesehen ist.

6. Aktorvorrichtung nach Anspruch 5, **dadurch gekennzeichnet, dass** das Kontaktelement eine Halteeinrichtung (9), bevorzugt in Form eines Gewindes und mehr bevorzugt in Form eines Innengewindes, aufweist.

7. Aktorvorrichtung nach Anspruch 5 oder 6, **dadurch gekennzeichnet, dass** das Kontaktelement einen Entkopplungsabschnitt aufweist, welcher die Einleitung von Kräften quer zur Längenänderungsrichtung des Aktors reduziert oder eliminiert.

8. Aktorvorrichtung nach einem der Ansprüche 5 bis 7, **dadurch gekennzeichnet, dass** das Kontaktelement integral mit dem Gehäuse ausgebildet ist.

9. Anordnung (10) mit einer Vielzahl von Aktorvorrichtungen (1) nach einem der vorhergehenden Ansprüche, **dadurch gekennzeichnet, dass** sich benachbarte Aktorvorrichtungen zumindest abschnittsweise, bevorzugt im Bereich des jeweiligen Basiselements, kontaktieren.

10. Anordnung nach Anspruch 9, **dadurch gekennzeichnet, dass** die Aktorvorrichtungen jeweils über das Basiselement mit einer Grundplatte (11) verbunden sind.

11. Anordnung nach Anspruch 9 oder 10, **dadurch gekennzeichnet, dass** die Aktorvorrichtungen in die Grundplatte (11) eingesetzt sind, so dass nur die Gehäuse oder die Kontaktelemente über die Grundplatte hinausragen.

## Claims

1. An actuator device (1) having at least four electrically activatable, variable-length actuators (2), to each of which a compressive force is applied in its length change direction by a separate housing (3) having an integrally formed springy section (5),
**characterized in that**
each housing (3) is embodied in one piece with a base element (4), which is common to all housings.

2. The actuator device according to Claim 1, **characterized in that** each housing (3) is surrounded by at least two adjacent housings (3).

3. The actuator device according to Claim 1 or 2, **characterized in that** the springy section is formed by slots (6) in the housing (3).

4. The actuator device according to any one of the preceding claims, **characterized in that** at least a part of the housings has an opening or a passage (7), into which the actuator can be inserted, preferably pushed, in its longitudinal alignment.

5. The actuator device according to any one of the preceding claims, **characterized in that** at least one housing (3) comprises a contact element (8), which is provided for contact with an element to be moved or deformed by the actuators.

6. The actuator device according to Claim 5, **characterized in that** the contact element comprises a holding unit (9), preferably in the form of a thread and more preferably in the form of an internal thread.

7. The actuator device according to Claim 5 or 6, **characterized in that** the contact element comprises a decoupling section, which reduces or eliminates the introduction of forces transversely to the length change direction of the actuator.

8. The actuator device according to any one of Claims 5 to 7, **characterized in that** the contact element is integrally formed with the housing.

9. An arrangement (10) having a plurality of actuator devices (1) according to any one of the preceding claims, **characterized in that** adjacent actuator devices are in contact at least in sections, preferably in the region of the respective base element.

10. The arrangement according to Claim 9, **characterized in that** the actuator devices are each connected via the base element to a base plate (11).

11. The arrangement according to Claim 9 or 10, **characterized in that** the actuator devices are inserted into the base plate (11), so that only the housings or the contact elements protrude beyond the base plate.

## Revendications

1. Dispositif actionneur (1) comportant au moins quatre actionneurs (2) pilotables électriquement et variables en longueur, qui sont sollicités chacun dans leur direction de modification en longueur par une force de compression au moyen d'une portion élastique (5) réalisée intégralement, à travers un boîtier séparé (3) dans lequel chacun d'eux est respectivement mis en place,
**caractérisé en ce que**
chaque boîtier (3) est réalisé d'un seul tenant avec un élément de base (4) commun pour tous les boîtiers.

2. Dispositif actionneur selon la revendication 1, **caractérisé en ce que** chaque boîtier (3) est entouré par au moins deux boîtiers (3) voisins.

3. Dispositif actionneur selon la revendication 1 ou 2, **caractérisé en ce que** la portion élastique est formée par des fentes (6) dans le boîtier (3).

4. Dispositif actionneur selon l'une des revendications précédentes, **caractérisé en ce qu'**une partie au moins des boîtiers présente une ouverture ou une traversée (7) dans laquelle l'actionneur peut être mis en place, de préférence par translation, dans son orientation longitudinale.

5. Dispositif actionneur selon l'une des revendications précédentes, **caractérisé en ce qu'**au moins un boîtier (3) présente un élément de contact (8) qui est prévu pour la mise en contact avec un élément à déplacer ou à déformer par les actionneurs.

6. Dispositif actionneur selon la revendication 5, **caractérisé en ce que** l'élément de contact présente un moyen de retenue (9), de préférence sous la forme d'un pas de vis et de manière particulièrement préférée sous la forme d'un taraudage.

7. Dispositif actionneur selon la revendication 5 ou 6, **caractérisé en ce que** l'élément de contact comprend une portion de découplage qui réduit ou élimine l'application de forces transversalement à la direction de modification en longueur de l'actionneur.

8. Dispositif actionneur selon l'une des revendications 5 à 7, **caractérisé en ce que** l'élément de contact est réalisé intégralement avec le boîtier.

9. Ensemble (10) comportant une multitude de dispositifs actionneurs (1) selon l'une des revendications précédentes, **caractérisé en ce que** des dispositifs actionneurs voisins se contactent au moins localement, de préférence dans la zone de l'élément de base respectif.

10. Dispositif actionneur selon la revendication 9, **caractérisé en ce que** les dispositifs actionneurs sont reliés chacun à une plaque de base (11) par l'élément de base.

11. Dispositif actionneur selon la revendication 9 ou 10, **caractérisé en ce que** les dispositifs actionneurs sont mis en place dans la plaque de base (11), de sorte que seuls les boîtiers ou les éléments de contact dépassent au-delà de la plaque de base.
